# FASCICULE DE BREVET EUROPEEN

(11) **EP 3 178 963 B1**
(45) Date de publication et mention de la délivrance du brevet: **07.11.2018**
(21) Numéro de dépôt: 16202568.8
(22) Date de dépôt: 07.12.2016
(51) Int. Cl.: C23C 16/02

(54) **PROCÉDÉ DE TRAITEMENT ET RÉCEPTACLE DE CONFINEMENT D'UNE ANODE DE PRODUCTION DE RAYONS X**
BEHANDLUNGSVERFAHREN UND EINSCHLUSSBEHÄLTER EINER ANODE, DIE RÖNTGENSTRAHLEN ERZEUGT
TREATMENT METHOD AND CONTAINER FOR CONFINING AN ANODE FOR PRODUCING X-RAYS

(30) Priorité: 08.12.2015 FR 1561985
(43) Date de publication de la demande: 14.06.2017
(73) Titulaire: Acerde, 73800 Sainte Helene du Lac (FR)
(72) Inventeur: HUOT, Guillaume, 73000 Chambery (FR); PETITJEAN, Ariane, 38530 Barraux (FR); ROBERT, Pierre-Olivier, 73490 La Ravoire (FR); FRANCART, Gregory, 38580 Allevard-les-Bains (FR); POIREL, Hervé, 38410 Saint-Martin d'Uriage (FR)
(74) Mandataire: Casalonga

(56) Documents cités:
- EP-A1- 0 709 873
- JP-A- 2001 176 435

## Description

La présente invention concerne le domaine des dispositifs émetteurs de rayons X, utilisés notamment pour la réalisation d'images, et plus particulièrement utilisés dans les scanners d'imagerie médicale.

La production de rayons X est obtenue par un matériau réfractaire, généralement du tungstène ou un alliage à base majoritaire de tungstène, sous l'effet d'un faisceau incident d'électrons dirigé vers et bombardant localement ce matériau.

Couramment, le matériau réfractaire se présente sous la forme d'un revêtement cible, généralement en tungstène-rhénium (W-Re), formé sur un disque en un autre matériau et s'étendant sur une zone annulaire d'une face du disque, l'ensemble étant appelé une anode. Cette anode présente un passage axial pour son montage sur l'extrémité d'un arbre d'entraînement en rotation, de telle sorte que le faisceau incident d'électrons balaye une piste annulaire du revêtement cible en un matériau réfractaire.

Le disque peut être en une seule pièce par exemple en graphite ou en alliage de molybdène ou comprendre une première couronne sur une face de laquelle le revêtement annulaire est réalisé et une deuxième couronne brasée sur l'autre face de la première couronne. La première couronne peut être en un matériau réfractaire, par exemple en un alliage à base de molybdène, en particulier en Titane-Zirconium-Molybdène (TZM) ou en molybdène pur, la deuxième couronne peut être en graphite et la couche ou joint de brasure liant les deux couronnes peut être en un matériau réfractaire, par exemple en zirconium (Zr), titane (Ti), niobium (Nb), hafnium (Hf), vanadium (V), molybdène (Mo), tungstène (W), rhénium (Re), tantale (Ta) ou tout autre métal ou alliage réfractaire.

Généralement, en fonctionnement, les vitesses de rotation de telles anodes peuvent atteindre environ 10 000 tours par minute. La température au point d'impact des électrons peut atteindre 2000°C, la température de l'anode, dans sa masse, s'établissant généralement aux environs de 1300°C.

Un tel fonctionnement génère de fortes contraintes thermomécaniques dans les anodes. Pour limiter ces contraintes, les anodes notamment de grandes dimensions peuvent être pourvues de fentes radiales régulièrement réparties, qui traversent axialement le disque et le revêtement et sont ouvertes radialement vers l'extérieur.

Le revêtement cible se dégradant progressivement, plus particulièrement sur la zone ou piste annulaire balayée par le rayonnement incident, il a été proposé différentes solutions pour réparer un tel revêtement.

Pour protéger les joints de brasure, il est connu de revêtir l'anode d'une couche de protection, hormis sur la zone annulaire devant recevoir le revêtement, cette couche de protection étant ensuite enlevée. Cette manière de faire est cependant fastidieuse et coûteuse.

Le brevet EP 0 709873 décrit un procédé de traitement d'un revêtement cible annulaire d'une anode, dans lequel les surfaces autres que ce revêtement cible annulaire sont munies d'une couche formant un masque de protection.

Selon l'invention telle que décrite dans la revendication 1, il est proposé un procédé de traitement d'une anode, qui comprend: placer l'anode dans un réceptacle de confinement, qui comprend un plateau sur lequel l'anode repose, une paroi annulaire en saillie par rapport à ce plateau, s'étendant autour de la paroi périphérique de l'anode, et un couvercle placé sur une face frontale de l'anode, de sorte que ladite paroi annulaire et ledit couvercle délimitent entre eux une ouverture annulaire délimitant une zone annulaire découverte sur la face frontale de l'anode disposée dans le réceptacle ; et réaliser au moins une opération de traitement de ladite zone annulaire de revêtement, mettant en oeuvre au moins un gaz de traitement.

Ainsi, hormis sur la zone annulaire de revêtement, l'anode peut être protégée lors de l'opération de traitement sans aucune intervention directe sur l'anode.

Le procédé peut comprendre : laisser subsister au moins un espace interne entre l'anode et le réceptacle de confinement.

Ledit espace interne peut être placé en regard d'un bord d'au moins un joint de brasure.

Le procédé peut comprendre : réaliser ladite opération de traitement après avoir introduit une matière sacrificielle de protection en poudre dans ledit espace interne.

Le procédé peut comprendre : faire s'écouler un gaz de protection au travers dudit au moins un espace interne pendant ladite opération de traitement.

Ladite anode peut comprendre deux couronnes superposées présentant entre elles une couche de liaison, une surface locale de l'anode incluant au moins un bord de ladite couche de liaison délimitant ledit espace interne.

L'invention telle que décrite dans la revendication 7 propose également un réceptacle de confinement contenant une anode en forme de disque.

Le réceptacle de confinement comprend un plateau sur lequel une des faces radiales de l'anode repose, une paroi annulaire en saillie par rapport à ce plateau, s'étendant autour de la paroi périphérique de l'anode, en regard de la périphérie de l'anode, et un couvercle placé sur une face frontale de l'anode ; de sorte que ladite paroi annulaire et ledit couvercle délimitent entre eux une ouverture annulaire délimitant une zone annulaire découverte sur la face frontale de l'anode disposée dans le réceptacle.

Au moins une surface locale interne du réceptacle peut laisser subsister au moins un espace interne entre cette surface locale interne et au moins une surface locale de l'anode disposée dans le réceptacle.

Ledit espace interne peut être situé en regard d'au moins un bord de ladite couche de liaison de l'anode disposée dans le réceptacle.

Ledit espace interne peut recevoir une matière de protection en poudre.

Le réceptacle de confinement peut comprendre au moins un orifice d'amenée d'un gaz dans ledit espace interne et un orifice de sortie de ce gaz.

Le réceptacle de confinement peut comprendre des moyens internes de centrage radial de l'anode sur ledit plateau.

Le couvercle peut présenter une partie de centrage radial coopérant avec une partie de centrage radial de l'anode.

Ladite paroi annulaire peut comprendre une paroi cylindrique en saillie par rapport au plateau et un anneau disposé sur le bord de cette paroi cylindrique.

Le réceptacle de confinement peut comprendre une cuvette incluant ledit plateau et au moins en partie ladite paroi annulaire.

Le plateau peut présenter des rainures mettant en communication un espace interne central et un espace interne annulaire périphérique.

Lesdites rainures peuvent être situées au-dessous de fentes radiales de l'anode disposée sur ledit plateau.

Le réceptacle de confinement peut présenter un orifice d'amenée d'un gaz dans un espace interne central.

Ladite paroi annulaire peut comprendre une partie annulaire inférieure solidaire du plateau et une partie annulaire supérieure reposant sur la partie annulaire inférieure.

Des réceptacles de confinement et leurs modes d'utilisation vont maintenant être décrits à titre d'exemples non limitatifs, illustrés par le dessin sur lequel :
- la figure 1 représente, en perspective, une anode apte à la production de rayons X ;
- la figure 2 représente une vue éclatée en coupe d'un réceptacle de confinement apte à recevoir l'anode de la figure 1 ;
- la figure 3 représente une vue en coupe d'une partie du réceptacle de confinement, recevant l'anode de la figure 1 ;
- la figure 4 représente une vue en coupe du réceptacle de confinement, assemblé, contenant l'anode de la figure 1 ;
- la figure 5 représente une vue de dessus de la figure 4 ;
- la figure 6 représente une vue en coupe d'un autre réceptacle de confinement contenant une autre anode ;
- la figure 7 représente une vue en coupe d'un autre réceptacle de confinement, assemblé, contenant l'anode de la figure 1 ;
- la figure 8 représente une vue en coupe, décalée angulairement, du réceptacle de confinement de la figure 7 ; et
- la figure 9 représente une vue en perspective plongeante d'une partie du réceptacle de confinement de la figure 7.

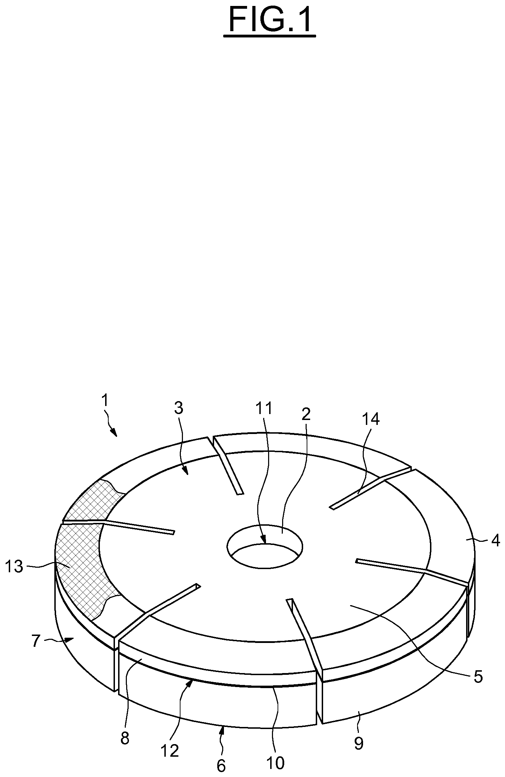

Selon un mode de réalisation, une anode circulaire rotative 1 de production de rayons X, illustrée sur la figure 1, en forme de disque, présente un passage axial central cylindrique de montage 2, pouvant recevoir une extrémité d'un arbre d'entraînement en rotation (non représenté).

L'anode 1 présente une face frontale 3 qui comprend une zone annulaire 4, légèrement tronconique, située autour d'une zone centrale radiale 5 traversée par le passage central 2, et qui présente une face arrière radiale 6 et une face ou champ périphérique cylindrique 7.

L'anode 1 est composée d'une première couronne 8 et d'une seconde couronne 9, qui sont superposées et fixées l'une sur l'autre par l'intermédiaire d'une couche radiale de liaison 10. La première couronne 8 présente la face frontale 3. La seconde couronne 9 présente la face arrière 6. Les faces ou champs périphériques des couronnes 8 et 9 constituent la face cylindrique 7 de l'anode 1. La couche radiale de liaison 10 présente un bord interne annulaire 11 contenu dans la paroi du passage central 2 et un bord externe annulaire 12 contenu dans le champ périphérique cylindrique 7.

La première couronne 8 est en un matériau réfractaire, par exemple en un alliage à base de molybdène, en particulier en Titane-Zirconium-Molybdène (TZM) ou en molybdène pur.

La deuxième couronne 9 est en graphite.

La couche radiale de liaison 10 est formée par un joint de brasure en un matériau réfractaire, par exemple en zirconium (Zr), titane (Ti), (Niobium) Nb, (Hafnium) Hf, vanadium (V), molybdène (Mo), tungstène (W), rhénium (Re), tantale (Ta) ou tout autre métal ou alliage réfractaire.

Sur la zone annulaire 4 de la face frontale 3 est présent un revêtement cible 13 qui comprend au moins un matériau apte à produire des rayons X sous l'effet d'un faisceau incident d'électrons. En utilisation, lors de la rotation de l'anode 1, le point d'impact du faisceau incident d'électrons décrit une piste locale annulaire sur le revêtement.

Le revêtement 13 de la zone annulaire 4 peut comprendre une couche ou un empilement de couches par exemple de tungstène, ou un alliage comprenant majoritairement du tungstène, par exemple du tungstène-rhénium, formée par frittage ou résultant d'un dépôt chimique en phase vapeur (CVD).

En outre, l'anode 1 présente une pluralité de fentes 14 ouvertes axialement des deux côtés et radialement vers l'extérieur, ces fentes 14 s'étendant axialement au travers des couronnes 8 et 9, de la couche de liaison 10 et du revêtement 13 et radialement depuis un endroit situé entre le passage central 2 et jusqu'à la surface périphérique 7. Les fentes 14 sont réparties angulairement et servent à limiter les contraintes mécaniques lors de l'utilisation de l'anode 1. Leur nombre peut dépendre du diamètre de l'anode 1 et peut être égal à trois ou un multiple de trois.

On va maintenant décrire un réceptacle de confinement 15 apte à contenir l'anode 1, dans le but de réaliser un traitement de cette dernière tout en protégeant notamment le joint de brasure 10.

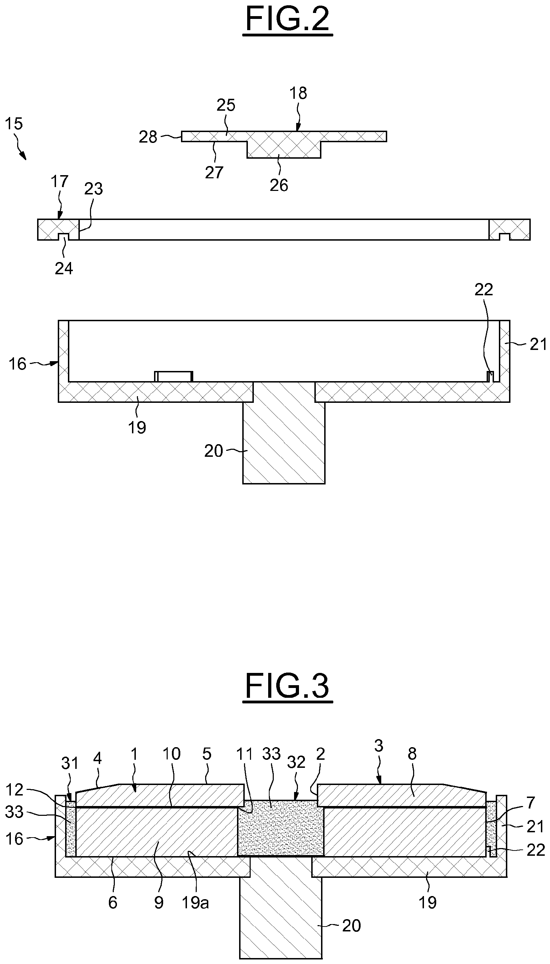

Comme illustré sur la figure 2, le réceptacle de confinement 15 comprend, sous la forme d'un kit, une cuvette 16, un anneau circulaire 17 et un couvercle circulaire 18.

La cuvette 16 comprend un plateau radial horizontal 19, monté sur l'extrémité supérieure d'un arbre vertical 20 d'une machine de dépôt (non représentée), et une paroi latérale cylindrique 21 en saillie vers le haut depuis le bord périphérique du plateau 19. A l'intérieur de la cuvette 16, sont prévus, par exemple, trois plots 22 en saillie qui servent au centrage de l'anode 1, voisins de la paroi cylindrique 21 et répartis angulairement à 120°.

Selon une variante de réalisation, la cuvette 16 pourrait comprendre deux parties séparables, l'une étant formée par le plateau 19 et l'autre étant formée par la paroi cylindrique 21. Par exemple, la paroi cylindrique 21 pourrait être posée et ajustée sur le bord périphérique du plateau 19 grâce à des épaulements complémentaires.

L'anneau circulaire 17 est par exemple de section rectangulaire et présente une face interne 23 cylindrique. Cet anneau 17 présente une rainure annulaire de centrage 24 dans l'une de ses faces radiales. L'anneau circulaire 17 peut être installé sur le bord de la paroi cylindrique 21, à distance du plateau 19, en engageant ce bord dans la rainure annulaire 24.

Le couvercle 18 comprend une plaque circulaire 25 et présente un bossage central cylindrique de centrage 26 en saillie d'un côté de cette plaque 25, de telle sorte que le couvercle 18 présente une face annulaire radiale 27 entourant le bossage 26.

Le réceptacle de confinement 15 peut être utilisé de la manière suivante.

Comme illustré sur la figure 3, on place l'anode 1 à l'intérieur de la cuvette 16 de telle sorte que la face arrière 6 de l'anode 1 soit en appui sur une face 19a du plateau 19 et que les plots de centrage 22 soient adjacents à la face périphérique 7 de l'anode 1. Ainsi, l'anode 1 repose sur le plateau 19 en étant centrée et la paroi cylindrique 21 est à distance de la face périphérique cylindrique 7 de l'anode 1.

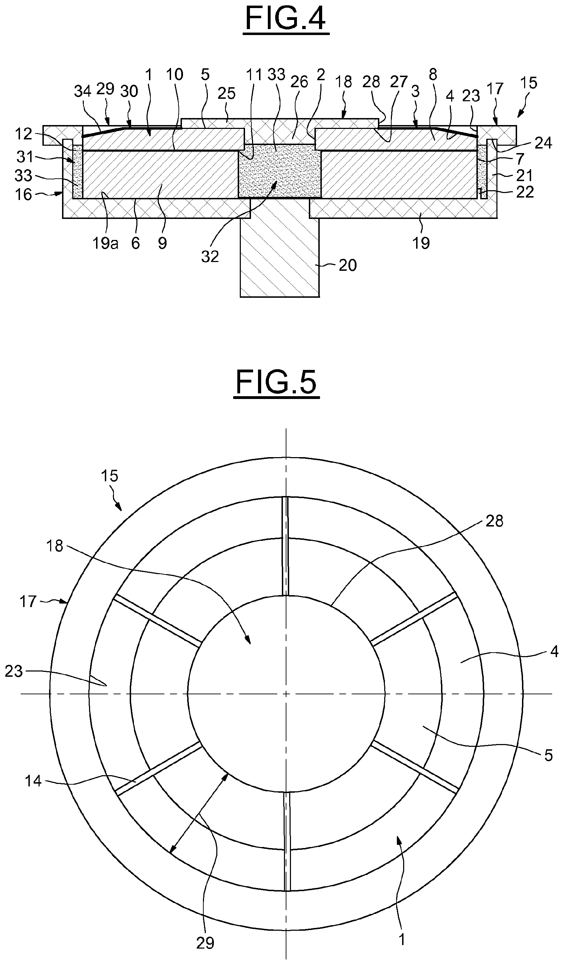

Ensuite, comme illustré sur les figures 4 et 5, on met en place l'anneau circulaire 17 et le couvercle 18 comme décrit ci-dessous.

On place l'anneau circulaire 17 sur le bord de la paroi cylindrique 21 de la cuvette 16, en engageant ce bord dans la rainure 24 de l'anneau circulaire 17, l'anneau circulaire 17 se plaçant autour de la partie supérieure de la face périphérique cylindrique 7 de l'anode 1, à distance au-dessus du bord externe 12 de la couche de liaison 10 de l'anode 1, et dépassant vers le haut. Dans cette position, la face cylindrique interne 23 de l'anneau circulaire 17 s'étend à une distance aussi faible que possible de la face périphérique cylindrique 7 de l'anode 1. Ainsi, la paroi cylindrique 21 de la cuvette 16 et l'anneau circulaire 17 constituent une paroi périphérique entourant l'anode 1. Néanmoins, l'anneau circulaire 17 pourrait présenter un rebord annulaire intérieur s'étendant au-dessus de la partie périphérique de la face frontale 3 de l'anode 1, ce rebord pouvant venir en contact sur cette partie périphérique.

On place le couvercle 18 sur l'anode 1, en engageant son bossage de centrage 26 dans le passage central 2 de l'anode 1, jusqu'à ce que la face annulaire radiale 27 du couvercle 18 repose sur la zone centrale radiale 5 de la face frontale 3 de l'anode 1. Dans cette position, le bord périphérique 28 du couvercle 18 est situé entre le passage central 2 et le bord intérieur de la zone annulaire tronconique 4 de l'anode 1. Ainsi, le réceptacle de confinement 15 présente une ouverture annulaire 29 entre l'anneau circulaire 17 et le couvercle circulaire 18.

Il résulte du montage ci-dessus que le réceptacle de confinement 15 enveloppe complètement l'anode 1, à l'exception d'une zone annulaire de revêtement 30 de la face frontale 3 de l'anode 1, qui reste découverte et qui correspond à l'ouverture annulaire 29, cette zone annulaire de revêtement 30 contenant la zone annulaire tronconique 4 munie ou non du revêtement 13 de l'anode 1.

Le réceptacle de confinement 15 délimite un espace interne annulaire 31 qui s'étend radialement entre la paroi cylindrique 21 de la cuvette 16 et la face périphérique 7 de l'anode 1 et axialement entre le plateau 19 et l'anneau 17. Ainsi, l'espace interne annulaire 31 est délimité entre des surfaces internes du réceptacle de confinement 15 et une surface périphérique locale de la face périphérique 7 de l'anode 1 incluant le bord externe 12 de la couche de liaison 10.

Le réceptacle de confinement 15 délimite également un espace interne central 32 dans le passage central 2 de l'anode 1, axialement entre le plateau 19 de la cuvette 16 et le couvercle 18 posé sur l'anode 1. Le bord interne 11 de la couche de liaison 10 de l'anode 1 est situé entre le plateau 19 et le bossage 26 du couvercle 18. Ainsi, l'espace interne central 32 est délimité entre des surfaces internes du réceptacle de confinement (le plateau 19 et le bossage 26 du couvercle 18) et une surface interne locale de la paroi du passage central 2 de l'anode 1 incluant le bord interne 11 de la couche de liaison 10.

La cuvette 16, l'anneau circulaire 17 et le couvercle circulaire 18, qui constituent le réceptacle de confinement 15, peuvent être en graphite.

On va maintenant décrire un mode d'utilisation du réceptacle de confinement 15.

Ayant placé l'anode 1 dans la cuvette 16 comme décrit précédemment en référence à la figure 3, on dépose dans l'espace annulaire 31, encore ouvert, entourant l'anode 1, dans les fentes 14 de l'anode 1 et dans le passage central 2, encore ouvert, de l'anode 1, une matière de protection 33 en poudre.

Cette matière est de même nature que le matériau constituant la couche de liaison 10, ou l'oxyde correspondant.

Puis, on met en place l'anneau 17 et le couvercle 18 comme décrit précédemment en référence aux figures 4 et 5.

Les espaces internes 31 et 32, ainsi que les fentes 14, sont alors, de préférence, complètement remplis de cette matière de protection en poudre 33.

Ensuite, on place le réceptacle de confinement 15 contenant l'anode 1 dans une enceinte de traitement, de façon à réaliser une couche de revêtement 34 sur la zone de revêtement 30 au travers de l'ouverture 29 du réceptacle 15.

La couche de revêtement 34, qui peut comprendre plusieurs sous-couches superposées, peut être réalisée par la technique de dépôt en phase vapeur (CVD). Cette couche de revêtement 34 comprend un matériau réfractaire apte à produire des rayons X sous l'effet d'un faisceau incident, généralement du tungstène (W) ou un alliage à base majoritaire de tungstène, par exemple un alliage de tungstène et de rhénium (W-Re).

Grâce au fait que le réceptacle de confinement 15 enveloppe l'anode 1 et à l'existence de la matière en poudre 33, qui est choisie en une matière apte à absorber et à réagir avec les gaz de traitement, la couche de liaison 10 de l'anode 1 est protégée contre son attaque par les gaz de traitement depuis ses bords 11 et 12, la matière en poudre 33 constituant une poudre sacrificielle. En outre, les surfaces de l'anode 1, autres que la zone de revêtement 30, sont protégées contre des dépôts intempestifs lors de l'opération de traitement précitée.

La couche de revêtement 34 étant réalisée, on sépare le couvercle 18, on sépare la bague annulaire 17, on extrait l'anode 1 de la cuvette 17 et on évacue la matière de protection en poudre 33.

L'anode 1 peut ensuite être traitée de façon à, éventuellement, ne conserver la couche de revêtement 34 que sur la zone périphérique tronconique 4, à nettoyer les fentes 14 de toutes matières et à rectifier la surface de la couche de revêtement 34 sur cette zone périphérique tronconique 4.

On peut obtenir, pour la première fois sur la face frontale de la couronne 8, le revêtement 13 précité, ou alors obtenir une réparation d'un revêtement préalable 13, abimé et réparé grâce au revêtement 34 réalisé au-dessus de ce revêtement préalable. En particulier, un procédé de réparation du revêtement mettant en oeuvre la technique de dépôt en phase vapeur (CVD) est décrit dans le brevet EP-A-2915900.

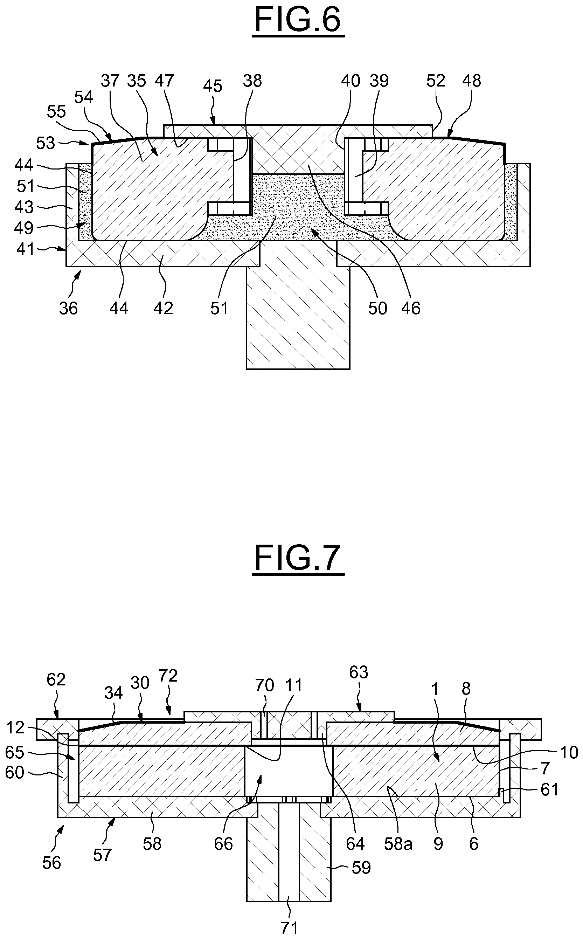

Selon un autre mode de réalisation illustré sur la figure 6, une anode circulaire 35 est placée dans un réceptacle de confinement 36.

L'anode circulaire 35 comprend un disque plein monobloc 37, par exemple en graphite, qui présente un passage central 38 dans lequel est fixé un insert métallique 39 délimitant un passage central cylindrique de montage 40. Cet insert peut être fixé par des joints de brasure.

Le réceptacle de confinement 36 comprend une cuvette 41, équivalente à la cuvette 16, qui comprend un plateau radial horizontal 42 et une paroi cylindrique 43 en saillie depuis le bord périphérique du plateau 42.

L'anode 35 est placée dans la cuvette 41 de façon que sa face radiale arrière 44 repose sur le plateau 42 et que la paroi cylindrique 43 s'étende autour et à distance de la face périphérique cylindrique 44 du disque 37.

Le réceptacle de confinement 36 comprend en outre un couvercle 45, équivalent au couvercle 18, qui comprend un bossage axial 46 engagé dans le passage central 40 de l'insert 39 et une face annulaire radiale 47 entourant le bossage 46 et venant en appui sur la partie annulaire intérieure de la face frontale 48 de l'anode 35.

Contrairement au mode de réalisation précédent, l'anneau 17 n'est pas présent.

De façon équivalente au mode de réalisation précédent, l'espace annulaire 49 entre la face périphérique cylindrique 44 de l'anode 35 et la paroi cylindrique 43 de la cuvette 41 et l'espace central 50 de l'anode 35, entre le plateau 42 et le bossage 46 du couvercle 45 sont remplis d'une matière de protection en poudre 51, équivalente à la matière de protection en poudre 33. Cette matière en poudre 51 est introduite après avoir mis en place l'anode 35 dans la cuvette 41 et avant la mise en place du couvercle 45 sur l'anode 35.

Le bord périphérique 52 du couvercle 45 et la matière en poudre 51 introduite dans l'espace périphérique 49 délimite une ouverture annulaire 53 à laquelle correspond une zone de revêtement 54 sur la face frontale 48 de l'anode 35, cette zone de revêtement 53 étant équivalente à la zone de revêtement 30 du mode de réalisation précédent.

La zone de revêtement 54 peut être traitée de façon équivalente au mode de réalisation précédent, pour réaliser une couche annulaire de revêtement 55 équivalente à la couche annulaire de revêtement 34.

Ainsi, de façon équivalente au mode de réalisation précédent, grâce au fait que le réceptacle de confinement 36 enveloppe l'anode 35 et à l'existence de la matière en poudre 51, qui est choisie en une matière apte à absorber et à réagir avec les gaz de traitement, les joints de brasure de l'insert 39 sur le disque 37 sont protégés contre une attaque par les gaz de traitement, la matière en poudre 51 constituant une poudre sacrificielle et les surfaces de l'anode 35, autres que la zone de revêtement 54, sont protégées contre des dépôts intempestifs lors de l'opération de traitement précitée.

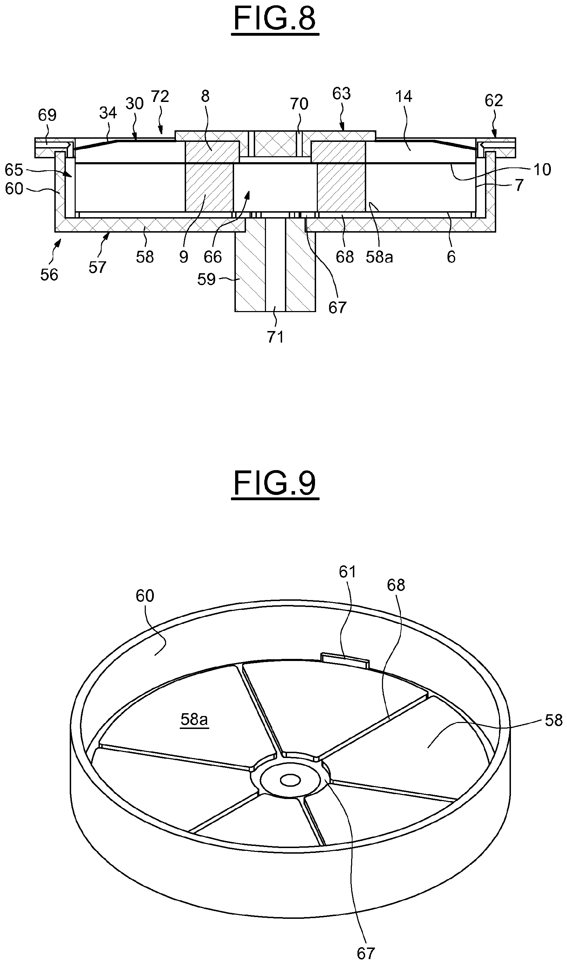

Selon un autre mode de réalisation illustré sur les figures 7, 8 et 9, un réceptacle de confinement 56 est destiné également à contenir l'anode circulaire 1 décrite en référence à la figure 1.

De façon équivalente au réceptacle de confinement 15, ce réceptacle de confinement 56 comprend une cuvette 57, qui comprend un plateau 58 monté sur l'extrémité supérieure d'un arbre 59 d'une machine de dépôt (non représentée) et une paroi cylindrique 60 et dans laquelle l'anode 1 peut être posée, la face arrière 6 de l'anode 1 étant en appui sur une face 58a du plateau 58 et l'anode 1 étant centrée par des plots en saillie 61.

Le réceptacle de confinement 56 comprend également un anneau circulaire 62, se plaçant sur le bord de la paroi cylindrique 60 de la cuvette 57, et un couvercle circulaire 63, se posant sur la partie centrale de la face frontale 3 de l'anode 1 pour fermer le passage central 2 de cette anode 1, le couvercle 63 comprenant un bossage de centrage 64 s'engageant dans le passage central 2 de l'anode 1.

De façon équivalente au réceptacle de confinement 15, sont ainsi délimités un espace interne annulaire 65 autour de la face périphérique 7 de l'anode 1 et un espace interne central 66 dans le passage central 2 de l'anode 1, l'espace interne annulaire 65 et l'espace interne central 66 étant équivalents aux espaces internes 31 et 32 délimités par le réceptacle de confinement 15.

Le réceptacle de confinement 56 se distingue du réceptacle de confinement 15 par le fait que le plateau 58 présente, dans sa face d'appui 58a, un évidement central 67 et une pluralité de rainures radiales 68 s'étendant au-dessous de l'anode 1, qui, lorsque l'anode 1 est posée sur cette face d'appui 58a du plateau 58, mettent en communication l'espace interne annulaire 65 et l'espace interne central 66.

En outre, l'anneau circulaire 62 présente une pluralité d'orifices traversants de sortie 69 mettant en communication l'espace interne annulaire 65 avec l'extérieur et le couvercle 63 présente une pluralité d'orifices traversants 70 mettant en communication l'espace interne central 66 avec l'extérieur. De plus, l'arbre 59 présente un orifice ou canal axial d'amenée 71 permettant de relier l'espace interne central 66 à une source de gaz sous pression.

Lorsque le réceptacle de confinement 56 contenant l'anode 1 est placé dans un four de traitement, dans le but de réaliser une couche de revêtement 34 au travers de l'ouverture annulaire 72 aménagée entre l'anneau 62 et le couvercle 63, on injecte un gaz neutre de protection dans l'espace interne central 66 via le canal axial 71 de l'arbre 59.

Le gaz de protection s'échappe de l'espace interne central 66 par les orifices traversants 70 du couvercle 63.

En outre, le gaz de protection s'écoule dans les rainures 68 du plateau 58 et est ainsi injecté dans l'espace interne annulaire 65, d'où il s'échappe par les orifices traversants 69 de l'anneau circulaire 62. Le gaz de protection peut également s'échapper par les éventuels interstices entre l'anneau circulaire 62 et l'anode 1 et entre le couvercle 63 et l'anode 1.

De plus, les rainures radiales 68 du plateau 58 et les fentes radiales 14 de l'anode 1 étant prévues avec les mêmes décalages angulaires et ayant pris soin de placer ces fentes 14 de l'anode 1 au-dessus de ces rainures 68, le gaz de protection s'écoule également au travers des fentes 14 de l'anode 1 et s'échappe vers l'extérieur au travers de l'ouverture 72 et/ou s'écoule vers l'espace interne annulaire 65.

La pression du gaz de protection injecté et les dimensions des rainures 68 et des orifices traversants 69 et 70 sont tels que les écoulements ci-dessus sont possibles et s'opposent à la pénétration des gaz de traitement dans les espaces internes 65 et 66.

Ainsi, la couche de liaison 10 de l'anode 1 est protégée contre son attaque par les gaz de traitement depuis ses bords 11 et 12 et les surfaces de l'anode 1, autres que la zone de revêtement 30, sont protégées contre des dépôts intempestifs lors de l'opération de réalisation de la couche de revêtement 34.

Selon un autre mode de réalisation, le réceptacle de confinement 36 pourrait présenter des dispositions équivalentes à celles du réceptacle de confinement 56. Ainsi, le plateau 42 de la cuvette 41 pourrait présenter des rainures pour mettre en communication les espaces internes 49 et 51 et le couvercle 45 pourrait présenter des orifices traversants, ces espaces internes pouvant être alimentés par un gaz de protection via un canal de l'arbre portant le plateau 42.

Selon un autre mode de réalisation, on pourrait combiner les exemples décrits ci-dessus, par exemple en disposant une matière de protection en poudre dans lesdits espaces internes et l'écoulement d'un gaz de protection au travers de ces espaces internes.

Selon un autre mode de réalisation, le ou les espaces internes du réceptacle de confinement pourraient être très réduits ou inexistants.

Selon un autre mode de réalisation, l'anode à traiter pourrait ne pas présenter de joint de brasure.

Selon un autre mode de réalisation, le réceptacle de confinement pourrait être utilisé pour tous autres traitements d'une anode que ceux mentionnés précédemment.

Selon un autre mode de réalisation, le réceptacle de confinement pourrait être appliqué à une anode ne présentant pas un passage central traversant, en particulier à une anode présentant un trou central cylindrique borgne ouvert à l'opposé de sa face frontale. Dans ce cas, le bossage de centrage radial 19 du couvercle 18 pourrait être engagé dans un évidement central borgne de centrage radial aménagé dans la face frontale d'une telle anode. Selon une variante de réalisation, l'anode pourrait présenter un bossage central en saillie engagé dans un évidement central borgne de centrage radial du couvercle.

## Revendications

1. Procédé de traitement d'une anode en forme de disque, pour la production de rayons X, comprenant :
placer l'anode (1 ; 35) dans un réceptacle de confinement (15 ; 36 ; 56) qui comprend un plateau (19 ; 42 ; 58) sur lequel l'anode repose, une paroi annulaire (21, 17 ; 43 ; 60, 62) en saillie par rapport à ce plateau, s'étendant autour de la paroi périphérique de l'anode, et un couvercle (18 ; 45 ; 63) placé sur une face frontale de l'anode, de sorte que ladite paroi annulaire et ledit couvercle délimitent entre eux une ouverture annulaire (29 ; 53; 72) délimitant une zone annulaire découverte sur la face frontale de l'anode disposée dans le réceptacle ; et
réaliser au moins une opération de traitement de ladite zone annulaire, mettant en oeuvre au moins un gaz de traitement.

2. Procédé selon la revendication 1, comprenant : laisser subsister au moins un espace interne (31, 32 ; 49 ; 50 ; 65, 66) entre l'anode et le réceptacle de confinement.

3. Procédé selon la revendication 2, dans lequel ledit espace interne est placé en regard d'un bord (11, 12) d'au moins un joint de brasure.

4. Procédé selon l'une des revendications 2 et 3, comprenant : réaliser ladite opération de traitement après avoir introduit une matière sacrificielle de protection (33 ; 51) en poudre dans ledit espace interne.

5. Procédé selon l'une quelconque des revendications 2 à 4, comprenant : faire s'écouler un gaz de protection au travers dudit au moins un espace interne pendant ladite opération de traitement.

6. Procédé selon l'une quelconque des revendications précédentes, dans lequel ladite anode comprend deux couronnes superposées (8, 9) présentant entre elles une couche de liaison (10) et dans lequel une surface locale de l'anode incluant au moins un bord (11, 12) de ladite couche de liaison délimite ledit espace interne.

7. Réceptacle de confinement contenant une anode en forme de disque pour la production de rayons X, comprenant :
un plateau (19 ; 42 ; 58) sur lequel une des faces radiales de l'anode repose,
une paroi annulaire (21, 17 ; 43 ; 60, 62) en saillie par rapport à ce plateau, s'étendant autour de la paroi périphérique de l'anode, en regard de la périphérie de l'anode,
et un couvercle (18 ; 45 ; 63) placé sur une face frontale de l'anode;
de sorte que ladite paroi annulaire et ledit couvercle délimitent entre eux une ouverture annulaire (29 ; 53; 72) délimitant une zone annulaire découverte sur la face frontale de l'anode disposée dans le réceptacle.

8. Réceptacle selon la revendication 7, dans lequel au moins une surface locale interne du réceptacle laisse subsister au moins un espace interne (31, 32 ; 49, 50 ; 65, 66) entre cette surface locale interne et au moins une surface locale de l'anode disposée dans le réceptacle.

9. Réceptacle selon la revendication 8, dans lequel ledit espace interne (31, 32 ; 65, 66) est situé en regard d'au moins un bord (11, 12) de ladite couche de liaison (10) de l'anode (1) disposée dans le réceptacle.

10. Réceptacle selon l'une des revendications 8 et 9, dans lequel ledit espace interne (31, 32 ; 49, 50) reçoit une matière de protection en poudre.

11. Réceptacle selon l'une quelconque des revendications 8 à 10, comprenant au moins un orifice (71) d'amenée d'un gaz dans ledit espace interne (65, 66) et un orifice de sortie (69 ; 70) de ce gaz.

12. Réceptacle selon l'une quelconque des revendications 7 à 11, comprenant des moyens internes (22 ; 61) de centrage radial de l'anode sur ledit plateau.

13. Réceptacle selon l'une quelconque des revendications 7 à 12, dans lequel le couvercle présente une partie de centrage radial (26) coopérant avec une partie de centrage radial de l'anode.

14. Réceptacle selon l'une quelconque des revendications 7 à 13, dans lequel ladite paroi annulaire comprend une paroi cylindrique en saillie (21 ; 43 ; 60) par rapport au plateau et un anneau (17 ; 62) disposé sur le bord de cette paroi cylindrique.

15. Réceptacle selon l'une quelconque des revendications 7 à 14, comprenant une cuvette (16 ; 41 ; 57) incluant ledit plateau (19 ; 42 ; 58) et au moins en partie ladite paroi annulaire (21 ; 43 ; 60).

16. Réceptacle selon l'une quelconque des revendications 7 à 12, dans lequel le plateau présente des rainures (68) mettant en communication un espace interne central (66) et un espace interne annulaire périphérique (65).

17. Réceptacle selon la revendication 16, dans lequel lesdites rainures sont situées au-dessous de fentes radiales de l'anode disposée sur ledit plateau.

18. Réceptacle selon l'une quelconque des revendications 7 à 17, présentant un orifice d'amenée (71) d'un gaz dans un espace interne central (66).

19. Réceptacle selon l'une quelconque des revendications 7 à 18, dans lequel ladite paroi annulaire comprend une partie annulaire inférieure (17 ; 60) solidaire du plateau et une partie annulaire supérieure (21 ; 62) reposant sur la partie annulaire inférieure.

## Patentansprüche

1. Behandlungsverfahren einer scheibenförmigen Anode zum Erzeugen von Röntgenstrahlen, umfassend:
Anordnen der Anode (1; 35) in einem Einschlussbehälter (15; 36; 56), der eine Platte (19; 42; 58), auf der die Anode aufliegt, eine ringförmige Wand (21, 17; 43; 60; 62), die in Bezug auf diese Platte vorsteht, die sich um die Umfangswand der Anode erstreckt, und eine Abdeckung (18; 45; 63) aufweist, die auf einer Vorderseite der Anode derart angeordnet ist, dass die ringförmige Wand und die Abdeckung zwischen sich eine ringförmige Öffnung (29; 53; 72) begrenzen, die einen ringförmigen Bereich begrenzt, der auf der Vorderseite der Anode freiliegt, die in dem Behälter angeordnet ist, und
Durchführen mindestens eines Behandlungsvorgangs des ringförmigen Bereichs unter Verwendung von mindestens einem Behandlungsgas.

2. Verfahren nach Anspruch 1, umfassend: Bestehenlassen von mindestens einem Innenraum (31, 32; 49; 50; 65, 66) zwischen der Anode und dem Einschlussbehälter.

3. Verfahren nach Anspruch 2, wobei der Innenraum gegenüber von einem Rand (11, 12) von mindestens einer Lötverbindungsstelle angeordnet ist.

4. Verfahren nach einem der Ansprüche 2 und 3, umfassend: Durchführen des mindestens einen Behandlungsvorgangs nachdem ein pulverförmiges Opferschutzmaterial (33; 51) in den Innenraum eingeführt worden ist.

5. Verfahren nach einem der Ansprüche 2 bis 4, umfassend: Strömenlassen eines Schutzgases durch den mindestens einen Innenraum während des Behandlungsvorgangs.

6. Verfahren nach einem der vorhergehenden Ansprüche, wobei die Anode zwei überlagerte Kränze (8, 9) aufweist, die zwischen sich eine Verbindungsschicht (10) aufweisen, und wobei eine lokale Fläche der Anode, die mindestens einen Rand (11, 12) der Verbindungsschicht einschließt, den Innenraum begrenzt.

7. Einschlussbehälter, der geeignet ist, eine scheibenförmige Anode zum Erzeugen von Röntgenstrahlen zu enthalten, umfassend:
eine Platte (19; 42; 58), auf der eine der radialen Flächen der Anode aufliegt,
eine ringförmige Wand (21, 17; 43; 60, 62), die in Bezug auf die Platte vorsteht, die sich um die Umfangswand der Anode gegenüber von dem Umfang der Anode erstreckt,
und eine Abdeckung (18; 45; 63), die auf einer Vorderseite der Anode angeordnet ist, derart, dass die ringförmige Wand und die Abdeckung zwischen sich eine ringförmige Öffnung (29; 53; 72) begrenzen, die einen ringförmigen Bereich begrenzt, der auf der Vorderseite der Anode freiliegt, die in dem Behälter angeordnet ist.

8. Behälter nach Anspruch 7, wobei mindestens eine lokale Innenfläche des Behälters mindestens einen Innenraum (31, 32; 49; 50; 65, 66) zwischen dieser lokalen Innenfläche und mindestens einer lokalen Fläche der Anode, die in dem Behälter angeordnet ist, bestehen lässt.

9. Behälter nach Anspruch 8, wobei sich der Innenraum (31, 32; 65, 66) gegenüber von mindestens einem Rand (11, 12) der Verbindungsschicht (10) der Anode (1), die in dem Behälter angeordnet ist, befindet.

10. Behälter nach einem der Ansprüche 8 bis 9, wobei der Innenraum (31, 32; 49, 50) ein pulverförmiges Schutzmaterial aufnimmt.

11. Behälter nach einem der Ansprüche 8 bis 10, der mindestens eine Öffnung (71) zum Zuführen eines Gases in den Innenraum (65, 66) und eine Auslassöffnung (69; 70) dieses Gases aufweist.

12. Behälter nach einem der Ansprüche 7 bis 11, umfassend innere Mittel (22; 61) zum radialen Zentrieren der Anode auf der Platte.

13. Behälter nach einem der Ansprüche 7 bis 12, wobei die Abdeckung einen Teil zum radialen Zentrieren (26) aufweist, der mit einem Teil zum radialen Zentrieren der Anode zusammenwirkt.

14. Behälter nach einem der Ansprüche 7 bis 13, wobei die ringförmige Wand eine zylindrische Wand (21 ;
43 ; 60), die gegenüber der Platte vorsteht, und einen Ring (17; 62) aufweist, der auf dem Rand dieser zylindrischen Wand angeordnet wird.

15. Behälter nach einem der Ansprüche 7 bis 14, der eine Vertiefung (16; 41; 57) aufweist, die die Platte (19; 42; 58) und mindestens einen Teil der ringförmigen Wand (21; 43; 60) einschließt.

16. Behälter nach einem der Ansprüche 7 bis 12, wobei die Platte Rillen (68) aufweist, die einen zentralen Innenraum (66) und einen peripheren ringförmigen Innenraum (65) in Verbindung bringen.

17. Behälter nach Anspruch 16, wobei sich die Rillen unter radialen Schlitzen der Anode befinden, die auf der Platte angeordnet ist.

18. Behälter nach einem der Ansprüche 7 bis 17, der eine Öffnung (71) zum Zuführen eines Gases in den Innenraum (66) aufweist.

19. Behälter nach einem der Ansprüche 7 bis 18, wobei die ringförmige Wand einen unteren ringförmigen Teil (17; 60), der mit der Platte fest verbunden ist, und einen oberen ringförmigen Teil (21; 62) aufweist, der auf dem unteren ringförmigen Teil aufliegt.

## Claims

1. Process for treating a disc-shaped anode for producing x-rays, comprising:
placing the anode (1; 35) in a confining receptacle (15; 36; 56) that comprises a platen (19; 42; 58) on which the anode rests, an annular wall (21, 17; 43; 60, 62) protruding with respect to this platen and extending around the peripheral wall of the anode, and a cover (18; 45; 63) placed on a frontal face of the anode, so that said annular wall and said cover define therebetween an annular aperture (29; 53; 72) defining an uncovered annular zone on the frontal face of the anode placed in the receptacle; and
carrying out a least one operation for treating said annular zone, implementing at least one treating gas.

2. Process according to Claim 1, comprising: leaving at least one internal space (31, 32; 49; 50; 65, 66) between the anode and the confining receptacle.

3. Process according to Claim 2, wherein said internal space is placed facing an edge (11, 12) of at least one braze joint.

4. Process according to one of Claims 2 and 3, comprising: carrying out said treating operation after a powdered sacrificial protective substance (33; 51) has been introduced into said internal space.

5. Process according to any one of Claims 2 to 4, comprising:
making a shielding gas flow through said at least one internal space during said treating operation.

6. Process according to any one of the preceding claims, wherein said anode comprises two superposed rings (8, 9) having therebetween a binding layer (10) and wherein a local surface of the anode including at least one edge (11, 12) of said binding layer defines said internal space.

7. Confining receptacle containing a disc-shaped anode for producing x-rays, comprising:
a platen (19; 42; 58) on which one of the radial faces of the anode rests;
an annular wall (21, 17; 43; 60, 62) protruding with respect to this platen and able to extend around the peripheral wall of the anode, facing the periphery of the anode;
and a cover (18; 45; 63) placed on a frontal face of the anode;
so that said annular wall and said cover define therebetween an annular aperture (29; 53; 72) defining an uncovered annular zone on the frontal face of the anode placed in the receptacle.

8. Receptacle according to Claim 7, wherein at least one internal local surface of the receptacle leaves at least one internal space (31, 32; 49, 50; 65, 66) between this internal local surface and at least one local surface of the anode placed in the receptacle.

9. Receptacle according to Claim 8, wherein said internal space (31, 32; 65, 66) is located facing at least one edge (11, 12) of said binding layer (10) of the anode (1) placed in the receptacle.

10. Receptacle according to one of Claims 8 and 9, wherein said internal space (31, 32; 49, 50) receives a powdered protective substance.

11. Receptacle according to any one of Claims 8 to 10, comprising at least one orifice (71) for admitting gas into said internal space (65, 66) and an orifice (69; 70) for exhausting this gas.

12. Receptacle according to any one of Claims 7 to 11, comprising internal means (22; 61) for centring the anode radially on said platen.

13. Receptacle according to any one of Claims 7 to 12, wherein the cover has a radially centring portion (26) interacting with a radially centring portion of the anode.

14. Receptacle according to any one of Claims 7 to 13, wherein said annular wall comprises a cylindrical wall (21; 43; 60) protruding with respect to the platen and an annulus (17; 62) placed on the edge of this cylindrical wall.

15. Receptacle according to any one of Claims 7 to 14, comprising a cup (16; 41; 57) including said platen (19; 42; 58) and at least partially said annular wall (21; 43; 60).

16. Receptacle according to any one of Claims 7 to 12, wherein the platen comprises grooves (68) bringing into communication a central internal space (66) and a peripheral annular internal space (65).

17. Receptacle according to Claim 16, wherein said grooves are located below radial slits in the anode placed on said platen.

18. Receptacle according to any one of Claims 7 to 17, comprising an orifice (71) for emitting a gas into a central internal space (66).

19. Receptacle according to any one of Claims 7 to 18, wherein said annular wall comprises a lower annular portion (17; 60) that is securely fastened to the platen and an upper annular portion (21; 62) resting on the lower annular portion.
